# EUROPÄISCHE PATENTSCHRIFT

(11) **EP 1 103 170 B1**
(45) Veröffentlichungstag und Bekanntmachung des Hinweises auf die Patenterteilung: **29.05.2002**
(21) Anmeldenummer: 99944326.0
(22) Anmeldetag: 03.08.1999
(51) Int. Cl.: H05K 7/20, H05K 1/02

(54) **LEITERPLATTE MIT EINEM HEATSINK UND VERFAHREN ZUM ANBRINGEN EINES HEATSINK**
PRINTED CIRCUIT BOARD WITH A HEATSINK AND METHOD FOR MOUNTING A HEATSINK
PLAQUETTE A CIRCUIT IMPRIME COMPORTANT UN PUITS THERMIQUE ET PROCEDE PERMETTANT DE MONTER LEDIT PUITS

(30) Priorität: 04.08.1998 DE 19835127
(43) Veröffentlichungstag der Anmeldung: 30.05.2001
(73) Patentinhaber: Würth Elektronik GmbH, 74585 Rot am See (DE)
(72) Erfinder: KOSTELNIK, Jan, D-74592 Kirchberg (DE)
(74) Vertreter: Patentanwälte , Ruff, Wilhelm, Beier, Dauster & Partner
(86) Internationale Anmeldenummer: EP9905616
(87) Internationale Veröffentlichungsnummer: WO0008903

(56) Entgegenhaltungen:
- DE-A- 3 716 196
- DE-A- 3 932 213
- DE-A- 3 935 662
- US-A- 5 590 462

## Beschreibung

Die Erfindung geht aus von einer Leiterplatte mit einem Heatsink. Es ist bekannt, ein als Heatsink dienendes Metallelement an einer Leiterplatte zu befestigen. Das Metallelement dient dazu, die in der Leiterplatten entstehende Wärme aufzunehmen und an die Umgebung abzugeben ; vgl. DE-A-3932213.

Der Erfindung liegt die Aufgabe zugrunde, eine Möglichkeit zu schaffen, im Bereich des Heatsink eine definierte Dielektrikumstärke vorzusehen.

Zur Lösung dieser Aufgabe schlägt die Erfindung eine Leiterplatte mit den Merkmalen des Anspruchs 1 sowie ein Verfahren mit den im Anspruch 5 genannten Merkmalen vor. Weiterbildungen der Erfindung sind Gegenstand der abhängigen Ansprüche, deren Wortlaut ebenso wie der Wortlaut der Zuammenfassung durch Bezugnahme zum Inhalt der Beschreibung gemacht wird.

Der die Kleberschicht zwischen der Leiterplatte und dem Metallelement begrenzende Rahmen hat die Aufgabe, dafür zu sorgen, daß die Kleberschicht an den Rändern eine genau definierte Fläche nicht überschreitet. Dadurch entsteht eine konstante Stärke des Dielektrikums.

In Weiterbildung der Erfindung kann vorgesehen sein, daß der Rahmen an der Leiterplatte durch die Kleberschicht angeklebt ist, die an seiner Innenseite zwischen dem Rahmen und dem Metallelement hochsteigt.

Erfindungsgemäß kann vorgesehen sein, daß die Kleberschicht von einer Klebefolie gebildet wird.

Es kann vorgesehen sein, daß die Verklebung durch eine Verpressung hergestellt ist.

Das von der Erfindung vorgeschlagene Verfahren sieht vor, den Rahmen an der Leiterplatte zumindest provisorisch zu fixieren oder zu positionieren und dann das Metallelement unter Zwischenlage einer Kleberschicht in den Rahmen einzuführen und gegen die Leiterplatte zu verpressen. Es kann vorgesehen sein, die Kleberschicht so zu bemessen, daß der Kleber am Rand an der Innenseite des Rahmens etwas hochsteigt und auf diese Weise den Rahmen ebenfalls an der Leiterplatte verklebt.

Die Erfindung schlägt vor, als Kleber eine Klebefolie zu verwenden.

Weitere Merkmale, Einzelheiten und Vorzüge der Erfindung ergeben sich aus der folgenden Beschreibung einer bevorzugten Ausführungsform der Erfindung sowie anhand der Zeichnung. Hierbei zeigen:
- Fig. 1: eine Aufsicht auf eine Ecke einer Leiterplatte mit einem Heatsink in einem Rahmen;
- Fig. 2: eine Seitenansicht der Anordnung nach Fig. 1.
- Fig. 3: schematisch die Einzelteile einer Anordnung nach der Erfindung;
- Fig. 4: einen Schnitt durch eine gegenüber Fig. 1 und 2 geänderte Ausführungsform.

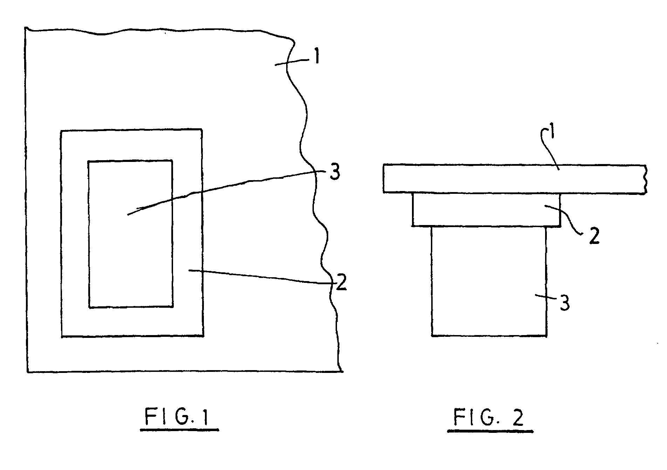

Fig. 1 zeigt stark vereinfacht schematisch eine Aufsicht auf eine Ecke einer Leiterplatte 1. An der Leiterplatte 1, die im übrigen einen normalen Aufbau aufweist, ist ein Rahmen 2 angebracht, innerhalb dessen ein metallisches Element 3 an der Leiterplatte angeklebt ist. Das metallische Element 3 wird von dem Rahmen 2 mit engem Abstand umgeben. Der verwendete Kleber ist ein Kleber mit einer guten thermischen Leitfähigkeit. Die Befestigung des metallischem Elements 3 an der Leiterplatte 1 geschieht so, daß der Rahmen 2 zunächst, beispielsweise mit Hilfe von Stiften, an der gewünschte Stelle positioniert wird. Dann wird eine Klebefolie in einer der entsprechenden Fläche des metallischen Elements 3 entsprechenden Größe in den Rahmen 3 auf die Leiterplatte 1 gelegt und dann das metallische Element 3 in den Rahmen eingesetzt. Anschließend wird das metallische Element 3 gegen die Leiterplatte 1 verpreßt.

Es ist ebenfalls möglich, die Klebefolie auf die Fläche des metallischen Elements 3 zu legen und dann dieses in den Rahmen 2 einzuführen.

Bei der Verpressung erfolgt eine Verklebung zwischen der Leiterplatte 1 und dem metallischen Element 3, wobei ggf. der Kleber seitlich an der Innenfläche des Rahmens 2 hochsteigt und damit auch eine Verklebung des Rahmens 2 an der Leiterplatte 1 bewirkt. Der Rahmen 2 verhindert, daß der Kleber bei der Verpressung über die durch die Innenseite des Rahmens 2 begrenzte Fläche herausgedrückt wird. Dadurch ergibt sich ein Dielektrikum genau festgelegter Größe.

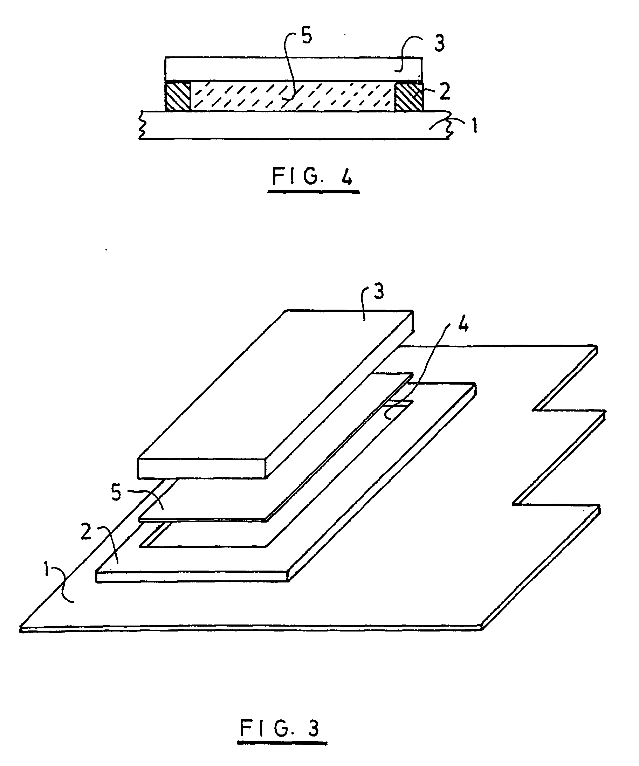

Figur 3 zeigt nun perspektivisch, wie der Heatsink 3 an einer Leiterplatte 1 angebracht wird. Auf der Leiterplatte 1 ist beispielsweise eine Kupferfolie mit oder ohne Bohrungen vorhanden, die gekühlt werden soll. Zunächst wird um diese Stelle der Rahmen 2 gelegt, wobei auch, wie eingangs erwähnt, eine Fixierung vorgenommen werden kann. Anschließend wird in das Innere 4 des Rahmens 2 Kleber in Form einer Kleberfolie 5 eingelegt. Dann wird das den Heatsink bildende metallische Element 3 ebenfalls in die Öffnung 4 des Rahmens eingesetzt und mit Hilfe der Kleberfolie 5 an der Leiterplatte 1 festgeklebt. Dadurch entsteht eine Anordnung, wie sie in den Figuren 1 und 2 dargestellt ist.

Je nach dem verwendeten Kleber und der Anwendung wird das Spaltmaß zwischen dem Rahmen 2 und dem Kleber gewählt.

Während bei der Ausführungsform nach Figur 2 der Heatsink 3 über den Rahmen von der Leiterplatte 1 übersteht, zeigt die Figur 4 eine Möglichkeit, wo der Heatsink 3 nicht innerhalb des Rahmens 2 angeordnet ist, sondern auf der der Leiterplatte 1 abgewandten Seite des Rahmens 2 aufliegt. Das Innere 4 des Rahmens 2 ist in diesem Fall vollständig von Kleber 5 ausgefüllt. Auch auf diese Weise kann eine definierte Dielektrikumsstärke erreicht werden.

Es ist ebenfalls möglich aber nicht dargestellt, dass der Heatsink 3 auch an einer oder mehreren Seiten über den Rahmen 2 überstehen kann. Dadurch lässt sich bei ebenfalls definierter Dielektrikumsstärke das Volumen des Heatsink und seine der Abstrahlung der Wärme dienende Oberfläche vergrößern.

Der Heatsink 3 kann natürlich auch andere Formen aufweisen.

## Patentansprüche

1. Leiterplatte, mit
1.1 einem als Heatsink wirkenden Metallelement (3), das
1.1.1 an der Leiterplatte (1) festgeklebt ist, sowie mit
1.2 einem Rahmen (2), der
1.2.1 das Metallelement (3) und
1.2.2 die diesen befestigende Kleberschicht umgibt .

2. Leiterplatte nach Anspruch 1, bei der der Rahmen (2) an der Leiterplatte (1) durch die Kleberschicht angeklebt ist, die an seiner Innenseite hochgedrückt wird .

3. Leiterplatte nach Anspruch 1 oder 2, bei der der Kleber eine Klebefolie ist .

4. Leiterplatte nach einem der vorhergehenden Ansprüche, bei der die Verklebung durch Verpressung erfolgt .

5. Verfahren zum Anbringen eines als Heatsink wirkenden Metallelements (3) an einer Leiterplatte (1), bei dem
5.1 an der Leiterplatte (1) ein Rahmen (2) zumindest vorübergehend fixiert wird,
5.2 in den Rahmen ein als Heatsink wirkendes Metallelement (3) unter Zwischenlage einer Kleberschicht eingesetzt und
5.3 gegen die Leiterplatte (1) verpreßt wird.

6. Verfahren nach Anspruch 5, bei dem der beim Verpressen an der Innenseite des Rahmens (2) hochsteigende Kleber dazu verwendet wird, den Rahmen an der Leiterplatte (1) zu verkleben.

7. Verfahren nach Anspruch 5 oder 6, bei dem als Kleber eine Klebefolie verwendet wird.

## Claims

1. Printed circuit board having
1.1 a metal element (3) acting as a heat sink and which
1.1.1 is bonded to the printed circuit board (1) and with
1.2 a frame, which
1.2.1 surrounds the metal element (3) and
1.2.2 the adhesive coating fixing the same.

2. Printed circuit board according to claim 1, wherein the frame (2) is bonded to the printed circuit board (1) by the adhesive coating, which is pressed up on its inside.

3. Printed circuit board according to claim 1 or 2, wherein the adhesive is an adhesive foil.

4. Printed circuit board according to one of the preceding claims, wherein bonding takes place by pressing.

5. Method for applying a metal element (3) acting as a heat sink to a printed circuit board (1), wherein
5.1 a frame (2) is at least temporarily fixed to the printed circuit board (1),
5.2 in the frame is inserted a metal element (3) acting as a heat sink and accompanied by the interposing of an adhesive coating and
5.3 is pressed against the printed circuit board (1).

6. Method according to claim 5, wherein the adhesive rising on the inside of the frame (2) during pressing is used to bond the frame to the printed circuit board (1).

7. Method according to claim 5 or 6, wherein an adhesive foil is used as the adhesive.

## Revendications

1. Plaquette de circuit imprimé avec
1.1 un élément métallique (3) agissant comme dissipateur de chaleur, qui
1.1.1 est collé sur la plaquette de circuit imprimé (1) ainsi qu'avec
1.2 un cadre (2) qui
1.2.1 entoure l'élément métallique (3)
1.2. et la couche de colle fixant celui-ci.

2. Plaquette de circuit imprimé selon la revendication 1, où le cadre (2) est collé sur la plaquette de circuit imprimé (1) par la couche de colle qui est pressée vers le haut contre la surface interne de ce dernier.

3. Plaquette de circuit imprimé selon la revendication 1 ou 2, où la colle est une feuille adhésive.

4. Plaquette de circuit imprimé selon l'une des revendications précédentes où le collage s'effectue par pressage.

5. Procédé pour l'application d'un élément métallique (3) faisant office de dissipateur de chaleur (3) sur une plaquette de circuit imprimé (1), où
5.1 un cadre (2) est au moins fixé provisoirement sur la plaquette de circuit imprimé (1),
5.2 un élément métallique (3) faisant office de dissipateur de chaleur est inséré dans le cadre en intercalant une couche de colle et
5.3 est pressé contre la plaquette de circuit imprimé (1).

6. Procédé selon la revendication 5, où l'adhésif montant lors de la compression contre la face interne du cadre (2) est utilisé pour coller le cadre sur la plaquette de circuit imprimé (1).

7. Procédé selon la revendication 5 ou 6, où on utilise une feuille adhésif comme colle.
